# FASCICULE DE BREVET EUROPEEN

(11) **EP 1 073 203 B1**
(45) Date de publication et mention de la délivrance du brevet: **09.10.2002**
(21) Numéro de dépôt: 00402167.1
(22) Date de dépôt: 27.07.2000
(51) Int. Cl.: H03K 17/10, G11C 16/12

(54) **Dispositif de commande d'un commutateur haute tension de type translateur**
Steuerschaltung für einen Pegelumsetzer-Hochspannungsschalter
Device for controlling a high voltage switch of the translator type

(30) Priorité: 30.07.1999 FR 9909970
(43) Date de publication de la demande: 31.01.2001
(73) Titulaire: STMicroelectronics S.A., 92120 Montrouge (FR)
(72) Inventeur: Fournel, Richard, 94230 Cachan (FR)
(74) Mandataire: Ballot, Paul

(56) Documents cités:
- EP-A- 0 774 838
- EP-A- 0 902 517
- GB-A- 2 201 059

## Description

La présente invention concerne un dispositif de commande d'un commutateur haute tension de type translateur.

Un exemple d'application concerne les circuits intégrés comprenant des mémoires none volatiles électriquement programmables.

Ces mémoires utilisent en effet pour leur programmation, une tension de niveau supérieur à la tension d'alimentation logique Vcc du circuit intégré. La valeur nominale de cette haute tension de programmation dépend essentiellement de la technologie considérée.

Pour appliquer cette haute tension à un élément du circuit intégré, par exemple pour l'appliquer sur une rangée d'une mémoire, on utilise habituellement un commutateur haute tension, appelé encore translateur de niveaux.

Ce commutateur reçoit en entrées, un signal logique de commande et une entrée haute tension. En fonction du niveau logique Vcc ou 0 du signal logique de commande, qui dans le cas d'une mémoire sera issu d'un signal de commande d'écriture, on obtient en sortie du commutateur, soit la masse, soit le niveau de l'entrée haute tension. Ces commutateurs sont bien connus de l'homme du métier.

Dans l'invention, on s'intéresse plus particulièrement aux commutateurs CMOS. Ils comprennent habituellement deux branches, avec dans chaque branche deux transistors en série entre l'entrée haute tension et la masse. Les transistors du bas sont de type N et ont leurs sources connectées à la masse. Ils sont encore appelés transistors de commutation, car ce sont eux qui reçoivent l'un le signal de commutation, et l'autre le signal inverse de commutation. Ces signaux de commutation sont des signaux logiques dont le niveau est 0 ou Vcc.

Les transistors du haut sont de type P et ont leurs sources connectées à un noeud recevant l'entrée haute tension. Ils ont chacun leur grille connectée au drain du transistor du haut de l'autre branche. Ils sont encore appelés transistors de charge.

Le principe de fonctionnement est le suivant : En fonction des niveaux des signaux de commutation, il y a toujours un transistor N de commutation qui est bloqué, le transistor N de commutation de l'autre branche étant passant. Ce transistor N passant tire son drain vers 0 volt (le potentiel de sa source), et le transistor P de l'autre branche qui a sa grille connectée à ce drain devient passant : il amène donc son drain propre à la tension de sa source, à savoir au niveau de l'entrée haute tension.

Ainsi, sur chaque noeud de connexion des drains des transistors N et P d'une même branche, on trouve soit la masse, soit le niveau de l'entrée haute tension.

Ces commutateurs comprennent habituellement un étage intermédiaire, entre l'étage des transistors du haut et l'étage des transistors du bas. Cet étage intermédiaire comprend un ou plusieurs étages cascodes. Il permet de limiter à des niveaux de tension intermédiaires les noeuds internes du commutateur, en sorte qu'aucun transistor du commutateur ne voit une trop haute tension à ses bornes.

Dans certains circuits de l'état de la technique, tous les transistors MOS(N ou P) de l'étage cascode sont polarisés sur leur grille par la tension d'alimentation logique Vcc. Cette polarisation limite la plage de fonctionnement du commutateur. Le basculement du commutateur pour obtenir en sortie le niveau de l'entrée haute tension ne peut en effet se faire que lorsque le niveau de l'entrée est suffisamment élevé, en pratique supérieur à la tension d'alimentation logique Vcc.

Or, avec les technologies MOS à oxyde fin, les basculements du commutateur en haute tension ont des effets transitoires néfastes sur les transistors MOS.

En outre, avec une telle polarisation des grilles des transistors cascodes à la tension d'alimentation logique alors que l'on retrouve sur les drains et sources des transistors cascodes une tension dépendant de l'entrée haute tension, il n'existe aucun lien entre ces tensions, ce qui peut engendrer des stress supplémentaires, si l'écart entre ces deux tensions devient trop important.

Pour ces raisons, on préfère polariser les grilles de ces transistors cascodes à une tension de référence obtenue à partir de l'entrée haute tension elle-même. Ainsi, peut-on contrôler l'écart de tension entre cette tension de référence et l'entrée haute tension, puisque la première dépend de la seconde, assurant ainsi une meilleure protection. Dans le cas d'un étage cascode à transistors MOS N et P, les grilles des transistors de type N de l'étage cascode sont alors habituellement polarisées à une tension de référence V_{REFₙ} supérieure à une tension de référence V_{REFₚ} qui polarise la grille des transistors de type P de l'étage cascode. Ceci permet d'abaisser la limite basse de basculement du commutateur.

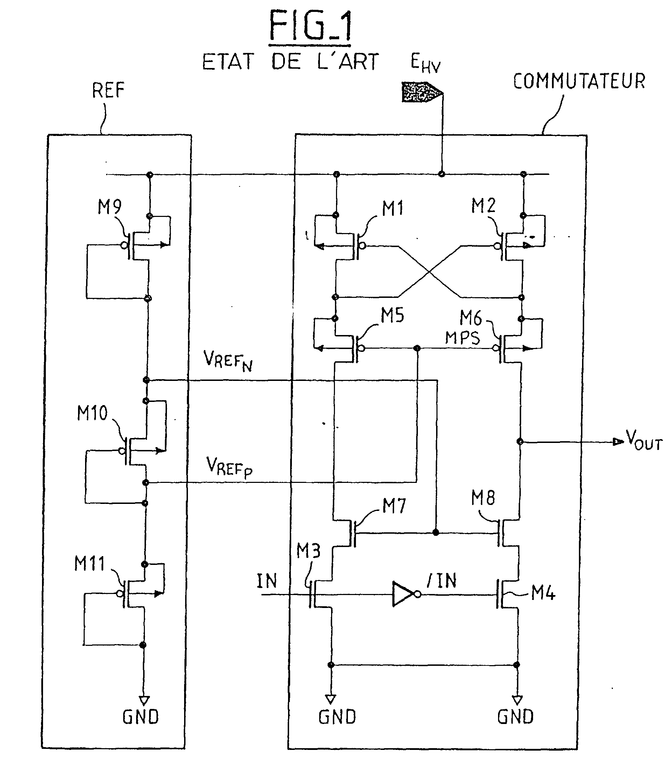

Un exemple d'un commutateur à étage cascode de ce type est représenté sur la figure 1.

Dans cet exemple, l'étage du haut comprend dans la première branche, un transistor Mos de type P, M1, et dans la deuxième branche, un transistor Mos de type P, M2. Ces transistors reçoivent sur leur source, l'entrée haute tension E_{HV}.

L'étage du bas comprend un transistor Mos de type N, M3, et dans la deuxième branche, un transistor Mos de type N, M4. Ces transistors ont leur source connectée à la masse G_{ND}.

L'étage cascode comprend quatre transistors Mos : deux transistors Mos de type P, M5 et M6, un dans chaque branche, sous chaque transistor du haut et deux transistors Mos de type N, M7 et M8, un dans chaque branche, au-dessus de chaque transistor du bas. Les transistors MOS P M5 et M6 reçoivent la tension de référence V_{REFₚ} sur leur grille. Les transistors MOS N M7 et M8 reçoivent la tension de référence V_{REFₙ} sur leur grille.

La sortie VOUT du commutateur est prise entre les transistors cascodes N et P d'une branche, aux drains des transistors M6 et M8 dans l'exemple.

La grille du transistor du bas M3 de la première branche du commutateur reçoit un signal logique de commutation noté IN, et la grille du transistor du bas M4 de la deuxième branche du commutateur reçoit le signal inverse, noté /I_{N}.

Le circuit REF de génération des tensions de référence V_{REFₙ} et V_{REFₚ} comprend trois transistors Mos M9, M10, M11 en série entre la haute tension V_{PP} et la masse. Ces trois transistors fonctionnent en résistance puisqu'il ont chacun leur grille reliée à leur drain. Dans l'exemple, ils sont de type P. Les tensions de référence V_{REFₙ} et V_{REFₚ} sont obtenues en prenant la tension de part et d'autre du transistor du milieu et M10.

Le rôle de l'étage cascode est de limiter à des niveaux intermédiaires les tensions vues par les transistors.

Chaque transistor cascode de type P est polarisé de manière à rester toujours passant. Ainsi sa source, et donc, le drain du transistor de charge P auquel il est connecté, ne peuvent pas descendre en dessous de V_{REFₚ} - Vtₚ, où Vtₚ est la tension de seuil du transistor cascode de type P.

De même, chaque transistor cascode de type N est polarisé de manière à rester toujours passant. Ainsi sa source, et donc, le drain du transistor de commutation N auquel il est connecté, ne peuvent pas monter au-dessus de V_{REFₙ} - Vtₙ, où Vtₙ est la tension de seuil du transistor cascode de type N.

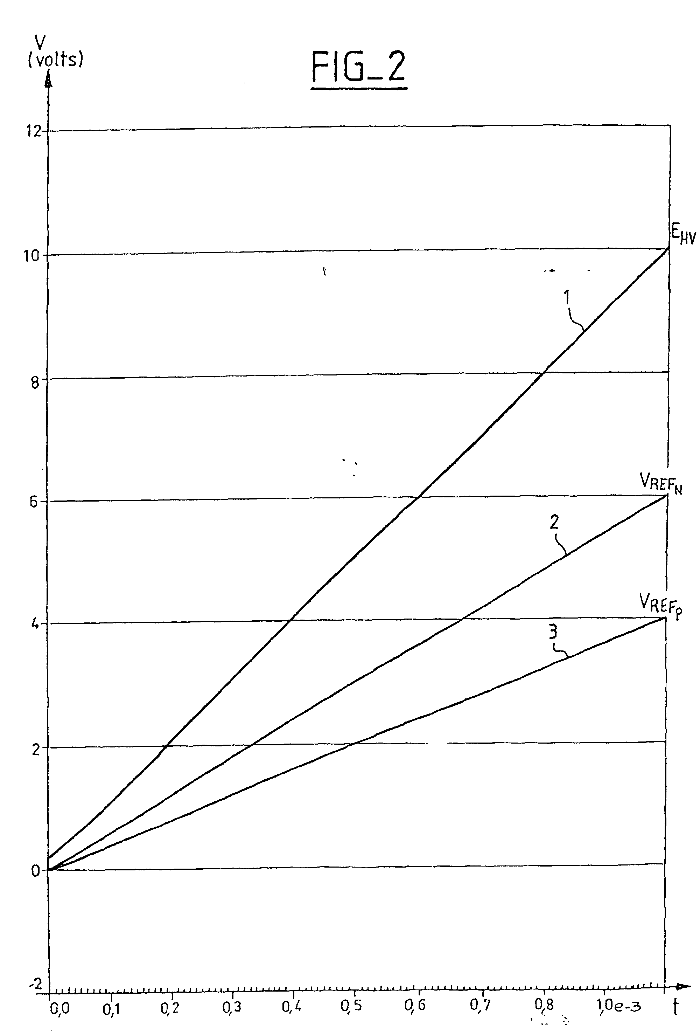

On considère un exemple pratique dans lequel l'entrée haute tension E_{HV} du commutateur se présente sous forme d'une impulsion avec une rampe de montée en tension, comme représenté sur la courbe 1 de la figure 2. Dans l'exemple il croît ainsi linéairement depuis zéro jusqu'à sa valeur nominale V_{PP} (la pente de croissance peut être linéaire, logarithmique exponentielle...).

Les deux courbes 2 et 3 représentent l'évolution des tension de référence, V_{REFₙ}, V_{REFₚ}.

Ces courbes montrent que ces tensions de référence suivent la montée en tension de l'entrée haute tension E_{HV}.

Elles montrent aussi que l'écart entre chacune de ces tensions de référence et le niveau de l'entrée haute tension E_{HV} au départ de la rampe, c'est à dire dans les valeurs basses de tension de l'entrée E_{HV}, ne permet pas aux différents transistors de l'étage cascode de conduire. Dans ces valeurs basses de l'entrée haute tension, le commutateur ne peut donc pas commuter. Dans un exemple pratique pour un circuit alimenté sous Vcc = 3,3 volts, il faut que le niveau de l'entrée haute tension devienne au moins supérieure à 3,8 volts, pour qu'il puisse commuter.

Or commuter dans des valeurs hautes de l'entrée E_{HV} c'est à dire supérieures à Vcc, a pour effet de contribuer à la production d'électrons chauds. La répétition des commandes de commutation multiplie ces électrons chauds. A terme cela dégrade les caractéristiques des transistors du commutateur.

Pour ces différentes raisons, les commutateurs de 'état de la technique ne supportent qu'un nombre limité de commutations.

Un objet de l'invention est de résoudre ce problème technique.

L'idée à la base de l'invention est de faire commuter le commutateur dans les valeurs basses de l'entrée haute tension. Une fois que les transistors ont commuté, le niveau de l'entrée haute tension peut monter, sans risques pour ces transistors.

Cette commutation dans les valeurs basses de l'entrée haute tension est réalisée, au moyen d'un circuit de commande commandé par un signal de contrôle binaire. Selon le niveau binaire "1" ou "0" de ce signal, ce circuit de commande permet d'imposer comme tensions de polarisation des grilles des transistors cascodes, soit la tension d'alimentation logique Vcc et la masse, soit les tensions de référence V_{REFₙ}, V_{REFₚ} de l'état de la technique. Ainsi, dans les valeurs basses de l'entrée haute tension, on peut forcer les niveaux des tensions d'alimentation logiques (Vcc et G_{ND}) comme tensions de polarisation des transistors cascodes, pour faire commuter le commutateur en basse tension.

Avec les grilles des transistors cascodes polarisées à Vcc (NMOS) et 0 volt (PMOS), on a en effet suffisamment de tension pour commander ces transistors. La commutation peut avoir lieu en basse tension. On n'a plus le problème de l'état de la technique, à savoir la génération d'électrons chauds. On améliore ainsi la résistance du commutateur. Ceci permet d'appliquer des règles de dessin moins contraignantes lors de la conception de ces transistors MOS critiques.

On notera que le commutateur peut toujours commuter dans les valeurs hautes de l'entrée haute tension. L'invention permet donc d'élargir la plage de fonctionnement du commutateur vers les valeurs basses de l'entrée haute tension, d'améliorer sa fiabilité et de simplifier ses règles de dessins.

Quand le basculement a eu lieu, on revient au fonctionnement habituel du circuit REF de génération des tensions de référence. La sortie du commutateur suit alors la montée en tension de l'entrée haute tension avec les avantages d'une polarisation des transistors cascodes par les tensions V_{REFₙ}, V_{REFₚ} fonctions de l'entrée haute tension.

L'invention concerne donc un dispositif de commande d'un commutateur d'une entrée haute tension, à transistors MOS et comprenant au moins un étage cascode, le dispositif comprenant un circuit de génération de tensions de référence à partir de l'entrée haute tension et fournissant en sortie une ou des tensions de polarisation des transistors Mos de l'étage cascode, caractérisé en ce qu'il comprend en outre un circuit de commande du circuit de génération de référence, contrôlé par un signal binaire, pour soit forcer les tensions de polarisation au niveau des tensions d'alimentation logiques Vcc et G_{ND}, permettant la commutation du commutateur même dans des valeurs basses de l'entrée haute tension, soit permettre l'établissement des tensions de polarisation par le circuit de génération de référence.

D'autres caractéristiques et avantages de l'invention sont détaillés dans la description suivante, faite à titre indicatif et non limitatif de l'invention et en référence aux dessins annexés dans lesquels :
- la figure 1 déjà décrite représente un commutateur de haute tension à étage cascode et un circuit de génération des tensions de référence appliquées aux transistors de l'étage cascode selon l'état de la technique ;
- la figure 2 représente les courbes de croissance des tensions de référence obtenues selon l'état de la technique ;
- la figure 3 représente un circuit de commande du circuit de génération des tensions de référence selon l'invention ;
- la figure 4 montre la forme du signal V_{OUT} obtenue en sortie du commutateur en fonction du signal de commande de commutation IN ;
- la figure 5 montre la forme de l'entrée haute tension, du signal de commande du circuit de commande selon l'invention ainsi que les courbes correspondantes des tensions de référence obtenues ;
- la figure 6 représente schématiquement un circuit intégré comprenant un commutateur selon l'invention permettant la programmation d'éléments mémoire ; et
- la figure 7 montre une variante de commande applicable au circuit de la figure 6.

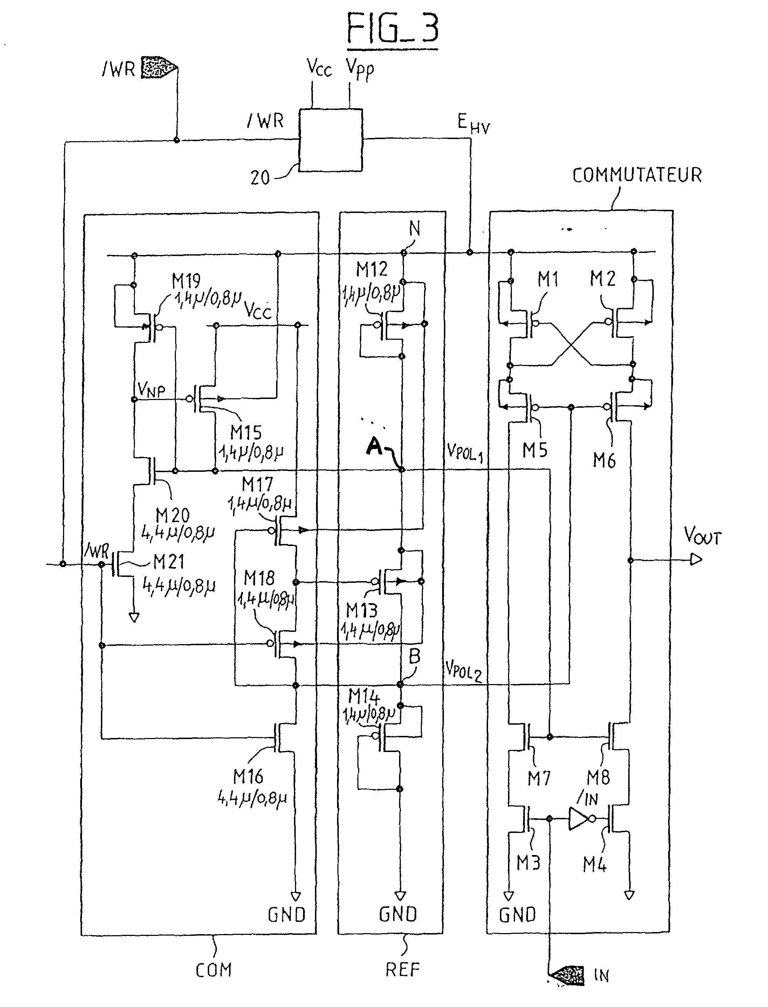

La figure 3 représente un dispositif de commande d'un commutateur d'une entrée haute tension E_{HV} selon l'invention.

Les éléments du commutateur sont identiques à ceux décrits en relation avec la figure 1. Aussi, pour la clarté de l'exposé, les éléments communs aux deux figures portent-ils les mêmes références.

Le dispositif de commande selon l'invention comprend un circuit REF de génération des tensions de référence et un circuit de commande COM. Le circuit REF comprend, comme dans l'état de la technique, trois transistors Mos de type P M12, M13 et M14, connectés en série entre le noeud N, recevant l'entrée haute tension E_{HV}, et la masse G_{ND}. Mais seuls le premier et le troisième transistors M12 et M14 ont chacun leur grille connectée à leur drain. Le deuxième transistor M13 est commandé par un circuit de commande COM selon l'invention. Son drain et sa source fournissent respectivement une première tension de polarisation V_{POL₁} et une deuxième tension de polarisation V_{POL₂}. Ce sont les tensions de polarisation de grille des transistors du ou des étages cascodes.

Le circuit de commande COM permet de contrôler la tension de grille, de drain et de source du deuxième transistor M13, selon le niveau d'un signal de contrôle /WR.

Lorsque le signal de contrôle /WR est à un premier niveau logique, 1 dans l'exemple, le drain et la source du transistor M13 sont respectivement forcés à Vcc et G_{ND}. On a alors V_{POL₁} = Vcc et V_{POL₂} = G_{ND}.

Lorsque le signal de contrôle /WR est au deuxième niveau logique, 0 dans l'exemple, le drain et la source du transistor M13 sont connectés ensemble, ce qui permet au circuit de référence d'établir les niveaux de tensions sur les noeuds A et B. On a alors V_{POL₁} = V_{REFₙ} et V_{POL₂} = V_{REFₚ}.

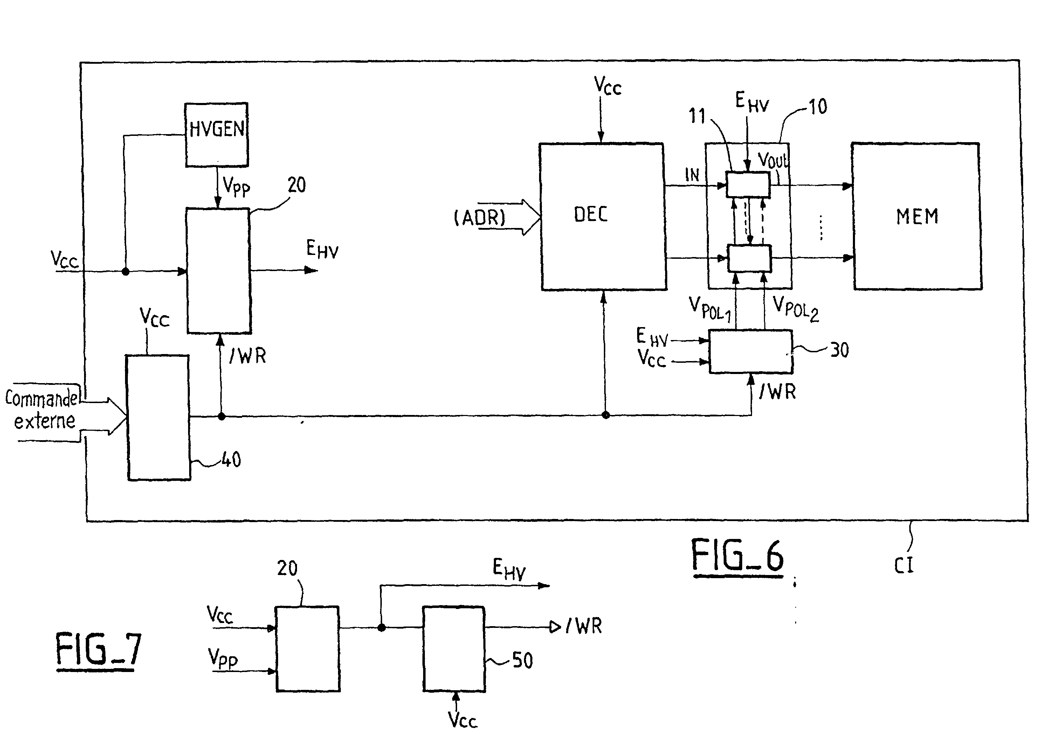

Un exemple d'application d'un commutateur haute tension commandé selon le principe de l'invention est représenté sur la figure 6.

Un circuit intégré CI comprend dans cet exemple un plan mémoire non volatile programmable électriquement, noté MEM.

L'accès à la mémoire est contrôlé par un décodeur DEC en fonction de signaux d'adresse et de commande (non représentés).

Les signaux de sortie du décodeur sont des signaux logiques.

Pour programmer la mémoire, il faut lui appliquer une tension de programmation. Un circuit 10 de commutateurs haute tension 11 est placé à cette fin entre le décodeur et la mémoire.

L'entrée de commande IN de chaque commutateur est fournie par un des signaux de sortie du décodeur.

Ces commutateurs reçoivent une entrée haute tension E_{HV} fournie par un circuit multiplexeur haute tension 20. Ils reçoivent les tensions de polarisation des transistors cascodes du dispositif de commande 30 selon l'invention.

Le circuit multiplexeur 20 reçoit en entrées, la tension d'alimentation logique Vcc et une haute tension V_{PP}, dans l'exemple fournie par un générateur de haute tension HVGEN (pompe de charges).

Il est commandé par un signal d'écriture /WR fourni par un circuit de contrôle 40 du circuit intégré, en fonction de signaux de commande externes.

Ce signal d'écriture /WR est appliqué aussi au dispositif de commande 30 qui fournit les tensions de polarisation des transistors cascodes aux commutateurs.

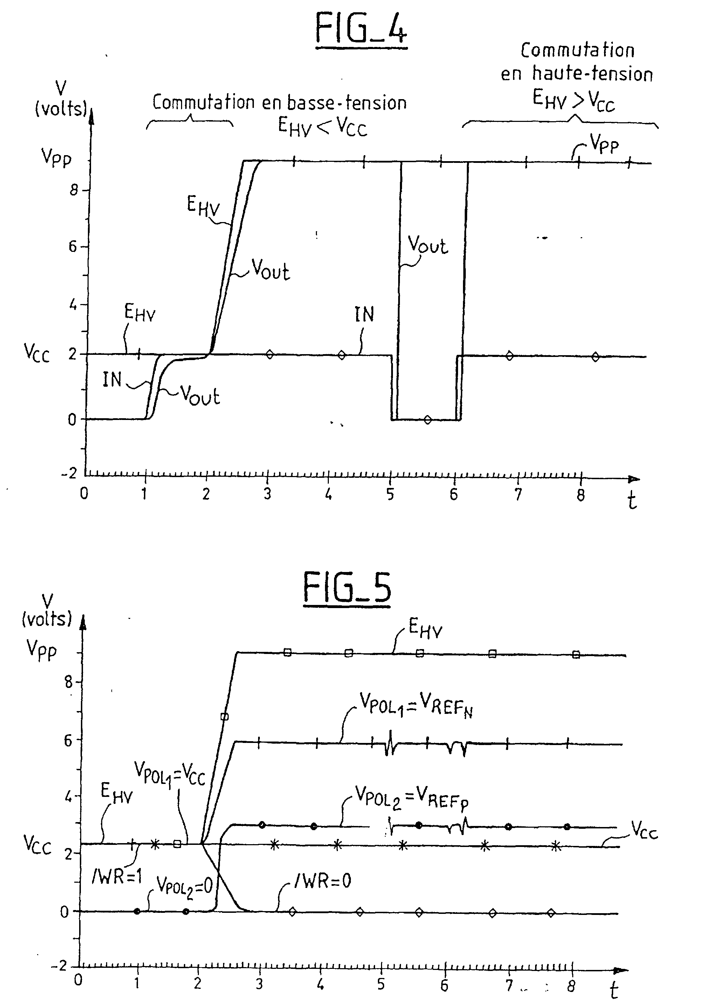

Le fonctionnement d'un commutateur avec un dispositif de commande selon l'invention lors d'un cycle d'écriture d'éléments de la mémoire est illustré sur les figures 4 et 5, dans un exemple pratique d'alimentation logique sous 2 volts (Vcc = 2 volts).

Les signaux IN, E_{HV}, V_{OUT} sont représentés sur la figure 4 et les signaux /WR, V_{POL₁} V_{POL₂} et E_{HV} sont représentés sur la figure 5.

Lorsque le signal d'écriture /WR vaut 1, le multiplexeur 20 applique Vcc sur l'entrée haute tension E_{HV} et le décodeur est activé pour délivrer en sortie des signaux de sélection fonction de signaux d'adresse (ADR) appliqués en entrée.

Si on prend un commutateur du circuit 10, son entrée logique IN de commande de commutation est fournie par une sortie du décodeur.

Quand cette entrée IN bascule de 0 à 1, pour faire commuter sur le noeud de sortie V_{OUT} du commutateur, le niveau de l'entrée haute tension E_{HV}, cette entrée E_{HV} est encore à un niveau inférieur ou égal à Vcc.

Les tensions de polarisation V_{POL₁} et V_{POL₂} sont alors forcées par le dispositif de commande 30 aux niveaux des tensions d'alimentation logiques, c'est à dire à respectivement Vcc (2 volts dans l'exemple) et G_{ND}.

Quand le signal de commande d'écriture /WR passe ensuite à son niveau actif d'écriture, 0 dans l'exemple, le dispositif de commande 30 change d'état pour forcer la connexion grille-drain du deuxième transistor M13 du circuit de génération de référence (Fig.3). On retrouve alors le fonctionnement du circuit de référence selon l'état de la technique : V_{POL₁} = V_{REFₙ} et V_{POL₂} = V_{REFₚ}.

Dans le même temps, le multiplexeur 20 applique la tension de programmation sur l'entrée haute tension E_{HV} sous forme d'une impulsion, avec une rampe de montée en tension depuis le niveau précédent Vcc, jusqu'à V_{PP}.

Les tensions de polarisation V_{POL₁} et V_{POL₂} suivent alors la montée de l'entrée haute tension E_{HV}, comme représenté sur la figure 5. Le signal de sortie V_{OUT} suit aussi l'entrée haute tension E_{HV}.

Le commutateur assure bien sa fonctionnalité de garder l'information de sortie pendant la montée de l'entrée haute tension E_{HV}.

Les perturbations sur les signaux V_{REFₙ} et V_{REFₚ} visibles sur la figure 5 sont liées aux basculements du commutateur (effet capacitif des transistors MOS M5 à M8).

Cet exemple d'application illustre bien le principe de commande logique d'un commutateur haute tension que permet le dispositif de commande selon l'invention, à savoir :
- commander le commutateur en sorte que la commutation soit réalisée lorsque le niveau de l'entrée haute tension E_{HV} est dans des valeurs basses (E_{HV} ≤ Vcc). Puis le commander en sorte qu'il assure ensuite sa fonction de maintien de l'information sur la sortie V_{OUT} en suivant la montée en tension de l'entrée haute tension E_{HV}.

Il reste que le commutateur peut toujours fonctionner comme dans l'état de la technique et commuter dans les valeurs hautes (E_{HV} > Vcc). Le dispositif de commande selon l'invention permet donc d'élargir la plage de fonctionnement du commutateur en lui permettant de basculer non seulement dans les valeurs hautes, comme dans l'état de la technique, mais aussi dans les valeurs basses (E_{HV} ≤ Vcc).

On notera que dans l'application de l'invention à la programmation d'éléments mémoire, l'invention s'applique aussi bien à la programmation d'éléments d'un plan mémoire, qu'à la programmation d'éléments mémoires discrets, répartis dans différents circuits interne d'un circuit intégré. Il peut notamment s'agir de fusibles électriquement programmables utilisés dans des circuits de redondance ou autres.

La figure 3 montre un exemple de réalisation détaillé d'un circuit de commande selon l'invention.

Ce circuit de commande comprend principalement quatre transistors Mos M15, M16, M17 et M18.

Le transistor Mos de type P M15 est connecté entre la tension d'alimentation logique Vcc et le premier noeud intermédiaire A du circuit de référence REF, connecté à la source du transistor M13.

Le transistor Mos de type N M16 est connecté entre le deuxième noeud intermédiaire B du circuit de référence, connecté au drain du transistor M13, et la masse G_{ND}.

Le transistor Mos de type P M17 est connecté entre la tension d'alimentation logique Vcc et la grille du transistor M13.

Le transistor M18 est connecté entre la grille du deuxième transistor et le deuxième noeud intermédiaire B, connecté au drain du transistor M13.

Les transistors M16 et M18 sont commandés sur leur grille par le signal de contrôle /WR du circuit de commande et le transistor M15 est commandé par un signal VNP référencé à l'entrée haute tension E_{HV} et issu du signal /WR et de logique inverse.

Le transistor M17 est connecté sur sa grille au deuxième noeud intermédiaire B.

Le fonctionnement de ce circuit de commande est le suivant :

Lorsque le signal /WR est à "1", le transistor M16 est passant et tire le deuxième noeud intermédiaire B à zéro, et par suite la grille du transistor M17.

Le transistor M18 lui est bloqué. Aussi, le transistor M17, qui lui est passant, amène la tension Vcc sur la grille du transistor M13, qui est ainsi forcé à l'état bloqué.

Le transistor M15 est lui aussi passant, puisque le signal VNP est de logique inverse au signal /WR. Il amène donc la tension Vcc sur le premier noeud intermédiaire A.

Comme le transistor M13 est forcé à l'état passant par les transistors M16, M17 et M18 du circuit de commande, les noeuds intermédiaires A et B sont confortés dans leurs niveaux respectifs Vcc et G_{ND}, quel que soit le niveau de tension sur l'entrée haute tension.

Lorsque le signal /WR passe à zéro, correspondant à la montée en tension de l'entrée haute tension E_{HV} depuis Vcc jusqu'à sa valeur nominale V_{PP}, les transistors M15 et M16 passent à l'état bloqué, et par suite le transistor M17 passe à l'état bloqué également. Le transistor M18 lui devient passant et connecte activement la grille du transistor M13 au deuxième noeud intermédiaire B, c'est à dire à son drain. Le transistor M13 se retrouve alors connecté en diode comme les autres transistors M12 et M14 du circuit de référence. On retrouve le fonctionnement normal du circuit de référence : les tensions aux noeuds A et B suivent la montée en tension de l'entrée haute tension E_{HV}.

Comme le transistor M15 du circuit de commande est connecté entre la tension d'alimentation logique Vcc et le noeud A et que le transistor M12 du circuit de référence est connecté entre l'entrée haute tension E_{HV} et le noeud A, lorsque cette entrée haute tension E_{HV} atteint les valeurs hautes, il faut être certain que le transistor M15 soit bien bloqué, pour ne pas envoyer de la haute tension vers la tension d'alimentation logique Vcc.

Pour cette raison, le transistor M15 doit recevoir sur sa grille non pas le niveau haut correspondant à la tension d'alimentation logique Vcc, mais celui issu de l'entrée haute tension E_{HV}. Quand l'entrée haute tension atteint sa valeur nominale V_{PP}, on retrouve cette valeur V_{PP} sur la grille du transistor M15.

Ceci est obtenu dans l'exemple au moyen d'un circuit inverseur à trois transistors Mos. Un premier transistor Mos de type P, M19, un deuxième transistor Mos de type N, M20 et un troisième transistor Mos de type N M21 sont connectés en série entre le noeud N l'entrée haute tension E_{HV} et la masse G_{ND}.

Le transistor M21 est commandé sur sa grille par le signal de contrôle /WR.

Les transistors M20 et M19 ont leurs grilles reliées ensemble au premier noeud intermédiaire A.

Le signal de logique inverse V_{NP} et référencé à E_{HV} par l'inverseur est fourni par le point de connexion série entre les deux transistors M19 et M20. C'est le signal appliqué sur la grille du transistor M15.

Le fonctionnement est simple. Lorsque le signal binaire /WR est à 1, le transistor M21 est passant et tire la source du transistor M20 à la masse. Le noeud A est à Vcc. Comme l'entrée haute tension E_{HV} est à ce moment à un niveau bas de tension (dans l'exemple, à Vcc, confère figure 4) Le transistor M19 est donc bloqué. Le transistor M20 lui est passant. On retrouve donc 0 volt sur la grille du transistor M15 : V_{NP}=0.

Les tailles des transistors MOS 19, 20 et 21 sont dimensionnées pour que, même si l'entrée haute tension E_{HV} prend une valeur supérieure à Vcc, V_{NP} reste inférieur à Vcc - Vₜₚ, en sorte que le commutateur fonctionne même dans les valeurs hautes de l'entrée haute tension (c'est à dire qu'il peut basculer).

Lorsque le signal binaire /WR est à 0, et que l'entrée haute tension E_{HV} monte de Vcc à V_{PP}, le transistor M21 n'est pas passant et met la source du transistor M20 à un potentiel flottant.

Le potentiel V_{NP} n'est pas tiré à la masse. Donc le transistor M15 est bloqué. Si l'entrée E_{HV} est à V_{PP}, Le noeud A est polarisé par le transistor M12 à une tension inférieure à V_{PP} - Vₜₚ. Le transistor M19 est passant et V_{NP} est tiré à V_{PP}. La position stable est donnée par V_{NP} = V_{PP}, M15 bloqué et V_{REFₙ} inférieur à V_{PP} -Vₜₚ.

On remarquera sur la figure 3 que les bulks des transistors M15, M17, M19 et M12 sont polarisés par l'entrée haute tension E_{HV}. Et les bulks des transistors M18 et M12 sont polarisés par la tension au premier noeud intermédiaire A, pour une meilleur tenue en tension.

L'invention qui vient d'être décrite permet d'améliorer la plage de fonctionnement et la fiabilité des commutateurs haute tension, en permettant sa commutation dans des valeurs basses de l'entrée haute tension. Sa réalisation pratique est un peu coûteuse, puisqu'elle comprend, dans l'exemple de réalisation décrit, sept transistors supplémentaires.

Cependant, et comme représenté sur la figure 6, il est possible d'avoir un seul dispositif de commande comprenant le circuit de référence et son circuit de commande pour plusieurs commutateurs.

Son utilisation dans un circuit intégré dont un exemple a été illustré en relation avec la figure 6, pour appliquer une impulsion de haute tension pour la programmation d'éléments mémoire non volatile électriquement programmables est particulièrement simple à mettre en oeuvre. En effet, dans ce type d'application le signal d'écriture /WR peut gérer à la fois le circuit qui fournit l'entrée haute tension (20, Fig.6) et le dispositif de commande.

Il suffit donc de modifier le séquencement du circuit de contrôle de la mémoire, en sorte qu'il produise un niveau actif du signal IN juste un peu avant le passage au niveau actif du signal d'écriture /WR, pour que le commutateur bascule juste un peu avant que l'impulsion d'écriture arrive sur l'entrée E_{HV}.

Dans une variante représentée sur la figure 7, on peut prévoir un détecteur de tension 50 sur l'entrée E_{HV} pour fournir le signal binaire /WR, en sorte que l'on ait /WR=1 lorsque le niveau de l'entrée haute tension est inférieur à un seuil déterminé (de l'ordre de Vcc) et /WR=0 lorsque le niveau de l'entrée haute tension est supérieur à ce seuil.

Dans cette variante, l'entrée E_{HV} n'a pas nécessairement la forme à deux paliers Vcc, V_{PP} représentée sur la figure 4.

Cette variante s'applique dans le cas où la montée en tension de l'entrée E_{HV} est suffisamment lente pour permettre au détecteur de commander le basculement du commutateur avant que l'entrée E_{HV} atteigne le seuil de détection.

L'invention ne se limite pas aux exemples de réalisation et d'application décrits. Elle s'étend aux dispositifs de commande comprenant un circuit de commande capable de forcer les niveaux de tension Vcc et G_{ND} comme tensions de polarisation des transistors cascodes du commutateur dans des valeurs basses de tension du signal E_{HV}. En outre, l'invention s'applique d'une manière générale à des commutateurs MOS à un ou plusieurs étages cascodes utilisant l'une ou les deux tensions de polarisation, selon que ces étages cascodes sont à transistors MOS N et P, à transistors MOS N ou à transistors MOS P.

## Revendications

1. Dispositif de commande d'un commutateur d'une entrée haute tension (E_{HV}), à transistors MOS et comprenant au moins un étage cascode, le dispositif comprenant un circuit de génération (REF) de tensions de référence (V_{REF_{N}}, V_{REF_{P}}) à partir de l'entrée haute tension (E_{HV}) et fournissant en sortie une ou des tensions de polarisation (V_{POL₁}, VP_{OL₂}) des transistors Mos de l'étage cascode, **caractérisé en ce qu'**il comprend en outre un circuit de commande (COM) du circuit de génération de référence (REF), contrôlé par un signal binaire (/WR), pour soit forcer les tensions de polarisation au niveau des tensions d'alimentation logiques Vcc et G_{ND} (V_{POL₁} = Vcc, V_{POL₂} = G_{ND}), permettant la commutation du commutateur même dans des valeurs basses de l'entrée haute tension (E_{HV}), soit permettre l'établissement des tensions de polarisation par le circuit de génération de référence (V_{POL₁} = V_{REFₙ,} V_{POL₂} =V_{REFₚ}).

2. Dispositif de commande selon la revendication 1, le circuit de génération de référence (R_{EF}) comprenant un premier transistor Mos de type P (M12), connecté entre un noeud (N) recevant l'entrée haute tension (E_{HV}) et un premier noeud intermédiaire (A), et ayant sa grille connectée à son drain, un deuxième transistor Mos de type P (M13) connecté entre le premier noeud intermédiaire (A) et un deuxième noeud intermédiaire (B) et un troisième transistor Mos de type P (M14) connecté entre le deuxième noeud et la masse, et ayant sa grille connectée à son drain, une tension de polarisation (V_{POL₁}, V_{POL₂}) étant obtenue sur l'un ou l'autre des noeuds intermédiaires, **caractérisé en ce que** le circuit de commande comprend des moyens de contrôle du deuxième transistor (M13) pour soit forcer le premier et le deuxième noeuds intermédiaires (A, B) aux niveaux des tensions d'alimentation logiques (Vcc, G_{ND}), soit relier activement la grille et le drain du deuxième transistor (M13), permettant l'établissement des niveaux de tension sur le premier et le deuxième noeuds intermédiaires par le circuit de génération de référence (REF).

3. Dispositif selon la revendication 2, **caractérisé en ce que** ces moyens de contrôle comprennent un premier transistor Mos (M15) connecté entre la tension d'alimentation logique (Vcc) et le premier noeud intermédiaire (A), un deuxième transistor Mos (M16) connecté entre le deuxième noeud intermédiaire (B) et la masse, un troisième transistor Mos (M17) connecté entre la tension d'alimentation logique (Vcc) et la grille du deuxième transistor (M13) du circuit de génération de référence et un quatrième transistor Mos (M18) connecté entre cette grille et le deuxième noeud intermédiaire (B), les premier, deuxième et quatrième transistors étant commandés par le signal binaire de contrôle (/WR), le troisième transistor étant commandé par le deuxième noeud intermédiaire (B).

4. Dispositif de commande selon la revendication 3, **caractérisé en ce que** les premier, troisième et quatrième transistors du circuit de commande sont des transistors Mos de type P et le deuxième transistor, un transistor Mos de type N, les deuxième et quatrième transistors recevant le signal binaire de contrôle sur leur grille, le premier transistor recevant un signal (V_{NP}) de logique inverse.

5. Dispositif selon la revendication 4, **caractérisé en ce que** ce signal de logique inverse (V_{NP}) est référencé à l'entrée haute tension (E_{HV}).

6. Dispositif selon la revendication 4 ou 5, **caractérisé en ce que** le signal de logique inverse est fournir par un circuit inverseur comprenant un premier transistor Mos de type P (M19), un deuxième transistor Mos de type N (M20) et un troisième transistor Mos de type N (M21) connectés en série entre l'entrée haute tension (E_{HV}) et la masse (G_{ND}), le point de connexion série entre le premier et le deuxième transistors fournissant le signal de logique inverse, les premier et deuxième transistors ayant leurs grilles reliées ensemble au premier noeud intermédiaire A et le troisième transistor étant commandé sur sa grille par le signal binaire (/WR).

7. Circuit intégré comprenant des éléments mémoire non volatile électriquement programmables, **caractérisé en ce qu'**il comprend au moins un dispositif de commande selon l'une quelconque des revendications précédentes, appliqué à au moins un commutateur d'une entrée haute tension pour la programmation des éléments mémoire.

8. Circuit intégré selon la revendication 7, **caractérisé en ce qu'**il comprend un dispositif de commande pour un ou plusieurs commutateurs.

9. Circuit intégré selon la revendication 7 ou 8, **caractérisé en ce qu'**il comprend des moyens (20) pour appliquer sur l'entrée haute tension (E_{HV}) soit la tension d'alimentation logique (Vcc) soit une tension de programmation (V_{PP}) sous forme d'une rampe, **caractérisé en ce que** ces moyens (20) et le circuit de commande sont commandés par le même signal binaire.

10. Circuit intégré selon la revendication 7 ou 8, **caractérisé en ce qu'**il comprend un détecteur de tension (50) pour fournir le signal binaire (/WR) du circuit de commande par comparaison du niveau de l'entrée haute tension (E_{HV}) à un seuil déterminé.

## Patentansprüche

1. Steuerschaltung für einen Wandler eines Hochspannungseingangs (EHV) mit MOS-Transistoren und wenigstens einer Kaskadenstufe, wobei die Schaltung einen Generatorschaltkreis (REF) für das Erzeugen von Referenzspannungen (VREF_{N}, VREF_{P}) aus dem Hochspannungseingang (EHV) und das Erzeugen am Ausgang einer oder mehrerer Vorspannungen (VPOL₁, VPOL₂) für MOS-Transistoren der Kaskadenstufe umfasst, **dadurch gekennzeichnet, dass** sie außerdem einen Steuerschaltkreis (COM) für den Referenzgeneratorschaltkreis (REF) umfasst, der gesteuert wird durch ein Binärsignal (/WR), um entweder die Vorspannungen auf den Pegel von den logischen Versorgungsspannungen VCC und GND (VPOL₁ = VCC, VPOL₂ = GND) zu zwingen, wodurch der Wandler selbst bei niedrigen Werten an dem Hochspannungseingang (EHV) wandelt, oder um das Aufbauen von Vorspannungen durch den Referenzgeneratorschaltkreis zu ermöglichen (VPOL₁ = VREFₙ, VPOL₂ = VREFₚ).

2. Steuerschaltung nach Anspruch 1, wobei der Referenzgeneratorschaltkreis (REF) einen PMOS-Transistor (M12), der zwischen einen Knoten (N), der mit dem Hochspannungseingang (EHV) verbunden ist, und einen ersten Zwischenknoten (A) geschaltet ist und dessen Gate mit seinem Drain verbunden ist, einen zweiten PMOS-Transistor (M13), der zwischen den ersten Zwischenknoten (A) und einen zweiten Zwischenknoten (B) geschaltet ist, und einen dritten PMOS-Transistor (M14) umfasst, der zwischen den zweiten Knoten und Masse geschaltet ist und dessen Gate mit seinem Drain verbunden ist, wobei sich eine Vorspannung (VPOL₁, VPOL₂) an dem einen oder anderen der Zwischenknoten ergibt, **dadurch gekennzeichnet, dass** der Steuerschaltkreis Steuervorrichtungen für den zweiten Transistor (M13) umfasst, um entweder den ersten und den zweiten Zwischenknoten (A, B) auf die Pegel der logischen Versorgungsspannungen (VCC, GND) zu zwingen, oder aktiv das Gate und den Drain des zweiten Transistors (M13) zu verbinden, wodurch das Aufbauen von Spannungspegeln an dem ersten und dem zweiten Zwischenknoten durch den Referenzgeneratorschaltkreis (REF) ermöglicht wird.

3. Steuerschaltung nach Anspruch 2, **dadurch gekennzeichnet, dass** die Steuervorrichtungen einen ersten MOS-Transistor (M15), der zwischen die logische Versorgungsspannung (VCC) und den ersten Zwischenknoten (A) geschaltet ist, einen zweiten MOS-Transistor (M16), der zwischen den zweiten Zwischenknoten (B) und Masse geschaltet ist, einen dritten MOS-Transistor (M17), der zwischen die logische Versorgungsspannung (VCC) und das Gate des zweiten Transistors (M13) des Referenzgeneratorschaltkreises geschaltet ist, und einen vierten MOS-Transistor (M18) umfasst, der zwischen dieses Gate und den zweiten Zwischenknoten (B) geschaltet ist, wobei der erste, zweite und vierte Transistor durch das binäre Steuersignal (/WR) gesteuert wird, wobei der dritte Transistor durch den zweiten Zwischenknoten (B) gesteuert wird.

4. Steuerschaltung nach Anspruch 3, **dadurch gekennzeichnet, dass** der erste, dritte und vierte Transistor des Steuerschaltkreises PMOS-Transistoren sind und der zweite Transistor ein NMOS-Transistor ist, wobei der zweite und vierte Transistor mit dem binären Steuersignal über ihr Gate angesteuert werden und der erste Transistor ein logisch inverses Signal (VNP) erhält.

5. Schaltung nach Anspruch 4, **dadurch gekennzeichnet, dass** sich das inverse logische Signal (VNP) auf den Hochspannungseingang (EHV) bezieht.

6. Schaltung nach Anspruch 4 oder 5, **dadurch gekennzeichnet, dass** das inverse logische Signal durch einen Inverterschaltkreis erzeugt wird, der einen ersten PMOS-Transistor (M19), einen zweiten NMOS-Transistor (M20) und einen dritten NMOS-Transistor (M21) umfasst, die in Reihe zwischen den Hochspannungseingang (EHV) und Masse (GND) geschaltet sind, wobei der serielle Verbindungspunkt zwischen dem ersten und dem zweiten Transistor das inverse logische Signal erzeugt und der erste und zweite Transistor über ihre Gates gemeinsam mit dem ersten Zwischenknoten A verbunden sind und der dritte Transistor über sein Gate durch das binäre Signal (/WR) gesteuert wird.

7. Integrierter Schaltkreis mit elektrisch programmierbaren nicht flüchtigen Speicherelementen, **dadurch gekennzeichnet, dass** er wenigstens eine Steuerschaltung nach einem der vorangehenden Ansprüche umfasst, die für wenigstens einen Wandler eines Hochspannungseingangs für die Programmierung von Speicherelementen verwendet wird.

8. Integrierter Schaltkreis nach Anspruch 7, **dadurch gekennzeichnet, dass** er eine Steuerschaltung für einen oder mehrere Wandler umfasst.

9. Integrierter Schaltkreis nach Anspruch 7 oder 8, **dadurch gekennzeichnet, dass** er Vorrichtungen (20) zum Anlegen entweder der logischen Versorgungsspannung (VCC) oder einer Programmierspannung (VPP) in Form einer Rampe an den Hochspannungseingang (EHV) umfasst, **dadurch gekennzeichnet, dass** die Vorrichtung (20) und der Steuerschaltkreis durch das gleiche binäre Signal gesteuert werden.

10. Integrierter Schaltkreis nach Anspruch 7 oder 8, **dadurch gekennzeichnet, dass** er einen Spannungsdetektor (50) umfasst für das Erzeugen des binären Signals (/WR) des Steuerschaltkreises durch Vergleich des Pegels des Hochspannungseingangs (EHV) mit einer vorgegebenen Schwelle.

## Claims

1. Device for controlling a switch with a high-voltage input (E_{HV}), with MOS transistors and comprising at least one cascode stage, the device comprising a circuit (REF) for generating reference voltages (V_{REF_{N}}, V_{REF_{P}}) from the high-voltage input (E_{HV}) and supplying as an output one or more voltages (V_{POL₁}, V_{POL₂}) for biasing the MOS transistors of the cascode stage, **characterised in that** it also comprises a circuit (COM) for controlling the reference generating circuit (REF), controlled by a binary signal (/WR), for either forcing the biasing voltages to the level of the logic supply voltages Vcc and G_{ND} (V_{POL₁} = Vcc, V_{POL₂} = G_{ND}), enabling the switching of the switch even in low values of the high-voltage input (E_{HV}), or allowing the establishment of biasing voltages by the reference generating circuit (V_{POL₁} = V_{REFₙ}, V_{POL₂} = V_{REFₚ}).

2. Control device according to Claim 1, the reference generating circuit (R_{EF}) comprising a first p-type MOS transistor (M12), connected between a node (N) receiving the high-voltage input (E_{HV}) and a first intermediate node (A), and having its gate connected to its drain, a second p-type MOS transistor (M13) connected between the first intermediate node (A) and a second intermediate node (B) and a third p-type MOS transistor (M14) connected between the second node and earth, and having its gate connected to its drain, a biasing voltage (V_{POL₁}, V_{POL₂}) being obtained on one or other of the intermediate nodes, **characterised in that** the control circuit comprises means of controlling the second transistor (M13) in order either to force the first and second intermediate nodes (A, B) to the levels of the logic supply voltages (Vcc, G_{ND}), or to actively connect the gate and drain of the second transistor (M13), enabling the establishment of the voltage levels on the first and second intermediate nodes by the reference generating circuit (REF).

3. Device according to Claim 2, **characterised in that** these control means comprise a first MOS transistor (M15) connected between the logic supply voltage (Vcc) and the first intermediate node (A), a second MOS transistor (M16) connected between the second intermediate node (B) and earth, a third MOS transistor (M17) connected between the logic supply voltage (Vcc) and the gate of the second transistor (M13) in the reference generating circuit and a fourth MOS transistor (M18) connected between this gate and the second intermediate node (B), the first, second and fourth transistors being controlled by the binary control signal (/WR), the third transistor being controlled by the second intermediate node (B).

4. Control device according to Claim 3, **characterised in that** the first, third and fourth transistors of the control circuit are p-type MOS transistors and the second transistor an n-type MOS transistor, the second and fourth transistors receiving the binary control signal at their gate, the first transistor receiving an inverse logic signal (V_{NP}).

5. Device according to Claim 4, **characterised in that** this inverse logic signal (V_{NP}) is referenced to the high-voltage input (E_{HV}).

6. Device according to Claim 4 or 5, **characterised in that** the inverse logic signal is supplied by an inverter circuit comprising a first p-type MOS transistor (M19), a second n-type MOS transistor (M20) and a third n-type MOS transistor (M21) connected in series between the high-voltage input (E_{HV}) and earth (G_{ND}), the serial connection point between the first and second transistors supplying the inverse logic signal, the first and second transistors having their gates connected together to the first intermediate node A and the third transistor being controlled at its gate by the binary signal (/WR).

7. Integrated circuit comprising electrically programmable non-volatile memory elements, **characterised in that** it comprises at least one control device according to any one of the preceding claims, applied to at least one switch with a high-voltage input for programming the memory elements.

8. Integrated circuit according to Claim 7, **characterised in that** it comprises a control device for one or more switches.

9. Integrated circuit according to Claim 7 or 8, **characterised in that** it comprises means (20) for applying to the high-voltage input (E_{HV}) either the logic supply voltage (Vcc) or a programming voltage (V_{PP}) in the form of a ramp, **characterised in that** these means (20) and the control circuit are controlled by the same binary signal.

10. Integrated circuit according to Claim 7 or 8, **characterised in that** it comprises a voltage detector (50) for supplying the binary signal (/WR) of the control circuit by comparing the high-voltage input level (E_{HV}) with a given threshold.
